# EUROPÄISCHE PATENTSCHRIFT

(11) **EP 3 409 439 B1**
(45) Veröffentlichungstag und Bekanntmachung des Hinweises auf die Patenterteilung: **13.10.2021**
(21) Anmeldenummer: 18171648.1
(22) Anmeldetag: 09.05.2018
(51) Int. Cl.: B29C 45/14, F21V 19/00, H01L 33/48, F21V 17/10, F21S 41/29

(54) **OPTIKVORRICHTUNG, BELEUCHTUNGSANORDNUNG, SCHEINWERFER UND VERFAHREN**
OPTICAL DEVICE, LIGHTING ASSEMBLY, HEADLAMP AND METHOD
DISPOSITIF OPTIQUE, AGENCEMENT D'ÉCLAIRAGE, PHARES ET PROCÉDÉ

(30) Priorität: 31.05.2017 DE 102017209239
(43) Veröffentlichungstag der Anmeldung: 05.12.2018
(73) Patentinhaber: OSRAM Beteiligungsverwaltung GmbH, 82031 Grünwald (DE)
(72) Erfinder: Feil, Thomas, 73574 lggingen (DE); Hartmann, Andreas, 98075 Ulm (DE)
(74) Vertreter: OSRAM GmbH - GC IP

(56) Entgegenhaltungen:
- EP-A1- 2 871 411
- WO-A2-2012/146390
- DE-A1-102008 057 355

## Beschreibung

Die Erfindung geht aus von einer Optikvorrichtung gemäß dem Oberbegriff des Anspruchs 1. Des Weiteren betrifft die Erfindung eine Beleuchtungsanordnung und einen Scheinwerfer mit einer derartigen Optikvorrichtung. Außerdem ist bei der Erfindung ein Verfahren zum Herstellen der Optikvorrichtung vorgesehen.

Nach dem Stand der Technik sind Scheinwerfer für Fahrzeuge bekannt, bei denen Strahlungsquellen, beispielsweise in Form von Licht emittierenden Dioden (LEDs), eine Primäroptik und Sekundäroptik nachgeschaltet ist. Bei der Anordnung der Primäroptiken sind hohe Toleranzanforderungen erforderlich, da diese präzise zur Strahlungsquelle justiert werden müssen. Eine derartige Primäroptik ist beispielsweise aus Silikon ausgebildet. Diese wird über einen Halterahmen an einer Leiterplatte befestigt, an der die Strahlungsquellen vorgesehen sind.

Die EP 2871411 A1 beschreibt ein optisches Element für eine Leuchte. Das optische Element weist wenigstens ein Linsenelement auf, das aus einem ersten Material besteht, sowie ein Halte-Element, das aus einem zweiten Material besteht, das sich in seinen optischen Eigenschaften von dem ersten Material unterscheidet. Das wenigstens eine Linsenelement und das Halte-Element sind derart integriert gestaltet, dass das optische Element einteilig ist. WO 2012/146390 zeigt einen weiteren bekannten Stand der Technik.

Die Aufgabe der vorliegenden Erfindung ist es, eine Optikvorrichtung zu schaffen, mit der auf vorrichtungstechnisch einfache Weise und mit geringen Toleranzen eine Optik an einer Leiterplatte befestigbar ist. Außerdem ist es die Aufgabe der Erfindung eine Beleuchtungsanordnung und einen Scheinwerfer zu schaffen, die auf vorrichtungstechnisch einfache Weise mit geringen Toleranzen herstellbar sind. Des Weiteren liegt der Erfindung die Aufgabe zugrunde ein einfaches Verfahren zum Herstellen einer Optikvorrichtung zu schaffen.

Die Aufgabe hinsichtlich der Optikvorrichtung wird gelöst gemäß den Merkmalen des Anspruchs 1, hinsichtlich der Beleuchtungsanordnung gemäß den Merkmalen des Anspruchs 8 und hinsichtlich des Scheinwerfers gemäß der Merkmalen des Anspruchs 9.

Sonstige vorteilhafte Ausgestaltungen finden sich in den abhängigen Ansprüchen.

Erfindungsgemäß ist eine Optikvorrichtung mit einer Optik vorgesehen. Des Weiteren hat die Optikvorrichtung einem Optikhalter, über den die Optik an einer Leiterplatte befestigbar ist, wobei eine Optikausnehmung in den Optikhalter eingebracht ist, wobei die Optik ausgehend von der Optikausnehmung eine Oberseite des Optikhalters und eine Unterseite des Optikhalters übergreift, wobei die Optik über ein Spritzgussverfahren hergestellt ist, und der Optik-halter von der Optik umspritzt ist, wobei der Optikhalter zumindest einen Funktionsabschnitt aufweist zur Beeinflussung einer Strahlungsverteilung einer Strahlung, die von zumindest einer der Optik zuordbaren Strahlungsquelle emittierbar ist, wobei der Funktionsabschnitt als ein Blendenabschnitt ausgebildet ist, der als Blende eingesetzt ist, und/oder wobei der Funktionsabschnitt als Reflexionsabschnitt ausgebildet ist.

Mit anderen Worten können die Optik und der Optikhalter zu einem Bauteil verschmelzen, wenn der Optikhalter beim Spritzgießen von der Optik umspritzt wird. Diese Lösung hat den Vorteil, dass mit geringem vorrichtungstechnischen Aufwand und mit einer äußerst geringen Anzahl von Bauteilen eine Befestigung der Optik an der Leiterplatte ermöglicht ist. Hinsichtlich der Bauteile sind lediglich der Optikhalter und die Optik notwendig, wobei keine zusätzlichen Verbindungselemente, wie beispielsweise Schrauben erforderlich sind, um die Optik mit dem Optikhalter zu verbinden. Durch die geringe Bauteileanzahl sind äußerst geringe Toleranzen umsetzbar, da eben im Unterschied zum Stand der Technik keine Vielzahl von Bauteilen erforderlich sind, die zu einer langen Toleranzkette führen können.

Die Optik ist vorzugsweise aus Silikon zumindest im Wesentlichen oder vollständig ausgebildet. Dies ist zum einen sehr kostengünstig und zum anderen kann damit der Optikhalter einfach umspritzt beziehungsweise umgossen werden.

In weiterer Ausgestaltung der Erfindung kann der Optikhalter einen Halteabschnitt für die Optik aufweisen. Des Weiteren kann er zumindest einen mit dem Halteabschnitt verbundenen Befestigungsschenkel für die Befestigung des Optikhalters an der Leiterplatte haben. Somit ist der Optikhalter vorrichtungstechnisch äußerst einfach ausgestaltet.

Der Halteabschnitt und der zumindest eine Befestigungsschenkel können als Flachteile ausgebildet sein. Der zumindest eine Befestigungsschenkel ist dann vorzugsweise angewinkelt zum Halteabschnitt angeordnet oder über einen Kurvenabschnitt mit dem Halteabschnitt verbunden. Durch den angewinkelten Befestigungsschenkel kann der Halteabschnitt auf einfache Weise beispielsweise von der Leiterplatte beabstandet werden. Durch die Ausbildung als Flachteile ist ein Bauraumbedarf des Optikhalters gering. Außerdem ist ein Materialaufwand und vorrichtungstechnischer Aufwand zum Herstellen des Optikhalters ebenfalls gering.

Vorrichtungstechnisch einfach kann der Optikhalter als Blechbiegeteil und/oder aus Metall ausgebildet sein. Beispielsweise wird dieser einfach von einem Blechband oder einer Blechplatte getrennt und im Anschluss gebogen. Alternativ kann vorgesehen sein, den Optikhalter vorrichtungstechnisch einfach aus Kunststoff auszubilden. Der Optikhalter kann dabei beispielsweise einfach in einem Kunststoffspritzgussverfahren hergestellt sein. Alternativ kann der Optikhalter auch aus einem anderen Material gebildet sein.

In weiterer Ausgestaltung der Erfindung hat der Optikhalter zumindest zwei Befestigungsschenkel. Diese können sich jeweils vom Halteabschnitt weg erstrecken und zusammen mit diesem U-förmig ausgebildet sein. Somit kann der Halteabschnitt über zumindest zwei Befestigungsschenkel an der Leiterplatte festgelegt werden, womit die mechanische Steifigkeit erhöht ist. Vorzugsweise sind die Befestigungsschenkel im Parallelabstand zueinander und/oder rechtwinklig zum Halteabschnitt ausgebildet. Alternativ ist auch denkbar, dass die Befestigungsschenkel V-förmig zueinander angeordnet sind und sich beispielsweise in der Richtung hin zum Halteabschnitt aneinander annähern. Eine U-förmige oder V-förmige Ausgestaltung des Optikhalters ist durch einen einfachen Biegeprozess und ein einfaches Biegewerkzeug realisierbar, falls der Optikhalter als Blechbiegeteil ausgestaltet ist. Ist der Optikhalter aus Kunststoff gebildet, so kann dieser hierdurch mit geringem Aufwand im Kunststoffspritzgussverfahren hergestellt werden.

An zumindest einem Befestigungsschenkel kann zumindest ein Anlageabschnitt vorgesehen sein. Dieser kann sich an dem zumindest einen Befestigungsschenkel anschließen und eine Anlagefläche für die Leiterplatte aufweisen. Sind zwei Befestigungsschenkel mit einem jeweiligen Anlageabschnitt vorgesehen, so können diese Anlageabschnitte in einer gemeinsamen Ebene angeordnet sein. Der/die Anlageabschnitt/e ist/sind vorzugsweise als Flachteil ausgebildet. Der/die Anlageabschnitt/e sind beispielsweise rechtwinklig zum zugeordneten Befestigungsschenkel ausgebildet, was vorrichtungstechnisch einfach und kostengünstig herstellbar ist. Der/die Anlageabschnitt/e erstreckt/erstrecken sich vom zugeordneten Befestigungsschenkel vorzugsweise nach außen.

In weiterer Ausgestaltung der Erfindung kann im Halteabschnitt eine, insbesondere durchgängige Optikausnehmung eingebracht sein. Über diese kann auf vorrichtungstechnisch einfache Weise die Optik am Optikhalter befestigt sein. Die Optikausnehmung ist dabei vorzugsweise von der Optik durchsetzt. Die Optik kann kraft- und/oder form- und/oder stoffschlüssig in der Optikausnehmung angeordnet sein, womit diese sicher am Optikhalter gehaltert ist.

Bei der bevorzugten Ausführungsform der Erfindung kann die Optik ausgehend von der Optikausnehmung eine, insbesondere von der Leiterplatte wegweisende, Oberseite des Halteabschnitts und/oder eine, insbesondere zur Leiterplatte weisende, Unterseite des Halteabschnitts übergreifen. Mit dem Übergreifen des Halteabschnitts kann eine sichere Halterung der Optik gewährleistet werden. Um ein einfaches Übergreifen zu ermöglichen kann ein von der Oberseite wegkragender Optikabschnitt der Optik und/oder ein von der Unterseite wegkragender Optikabschnitt der Optik breiter als die Optikausnehmung sein. Vorzugsweise liegt die Optik an der Oberseite und/oder Unterseite des Halteabschnitts an, womit sich die Optik abstützen kann.

In weiterer Ausgestaltung der Erfindung kann die Optik und/oder der Optikhalter zumindest eine oder jeweils zumindest eine Markierung aufweisen. Hierdurch kann bei der Montage des Optikhalters mit der Optik an der Leiterplatte eine einfache Justage ermöglicht werden. Dadurch wird der Toleranzeinfluss des Halters in einer X- und Y-Richtung, also in einer Ebene parallel zur Leiterplatte eliminiert.

Mit Vorteil ist der Optikhalter als Kühlelement für die Optik eingesetzt. Somit kann der Optikhalter neben der Haltefunktion auch eine Kühlfunktion übernehmen.

Erfindungsgemäß ist der Optikhalter zumindest einen Funktionsabschnitt zur Beeinflussung einer Strahlungsverteilung einer Strahlung, die von zumindest einer der Optik zugeordneten Strahlungsquelle emittierbar ist, eingesetzt. Somit erfüllt der Optikhalter eine Doppelfunktion, nämlich zum einen die Optik sicher zu halten und zum anderen die Strahlungsverteilung zu beeinflussen.

Der Funktionsabschnitt ist erfindungsgemäß als ein Blendenabschnitt ausgebildet, der als Blende oder Shutter einsetzbar ist. Mit anderen Worten kann der Optikhalter eine oder mehrere Konturen aufweisen, welche aktiv eine Lichtverteilung verändern können. Es ist denkbar, dass der Blendenabschnitt unterschiedlichste Formen annimmt und beispielsweise zu einem charakteristischen Knick eines Abblendlichts eines Fahrzeugscheinwerfers oder zu einer besonderen Form eines sogenannten "Cut-offs" bei Motorradbeleuchtungen führt. Außerdem kann dieser Blendenabschnitt oder zumindest ein Teil des Blendenabschnitts eine geringere Materialdicke als der restliche Optikhalter oder zumindest eines Teils des restlichen Optikhalters aufweisen, was zu einer besseren Abbildungsqualität führt.

Vorzugsweise hat der Blendenabschnitt oder der Optikhalter oder der Halteabschnitt und/oder der zumindest eine Befestigungsabschnitt auf seiner/ihrer zur/von der Strahlungsquelle oder Leiterplatte weisenden und/oder wegweisenden Seite eine strahlungsabsorbierende und/oder strahlungsreflektierende Oberfläche. Hierdurch kann auf einfache Weise eine Strahlungsverteilung beeinflusst werden.

In weiterer Ausgestaltung der Erfindung kann vorgesehen sein, dass der Blendenabschnitt vorrichtungstechnisch einfach ein Teil des Halteabschnitts ist. Beispielsweise kann der Blendenabschnitt von der Optik, insbesondere auf der Oberseite und/oder Unterseite des Halteabschnitts, übergriffen sein. Somit kann auf einfache Weise ein Teil der in die Optik eintretenden Strahlung abgeblendet werden. Der Blendenabschnitt erstreckt sich vorzugsweise vorrichtungstechnisch einfach ausgehend von der Optikausnehmung. Beispielsweise kann vorgesehen sein, dass dann zumindest ein Wandlungsabschnitt der Optikausnehmung eine Blendenkante bildet.

Bei einer bevorzugten Ausführungsform kann der Funktionsabschnitt oder ein weiterer Funktionsabschnitt als Reflexionsabschnitt ausgebildet sein, um eine Strahlungsverteilung zu beeinflussen. Vorrichtungstechnisch einfach ist der Reflexionsabschnitt hierbei ein Teil des Halteabschnitts und/oder ein Teil des oder der Befestigungsschenkel. Der Reflexionsabschnitt kann auf seiner zur Leiterplatte weisenden Seite und/oder auf seiner von der Leiterplatte wegweisenden Seite reflektierend ausgebildet sein.

Es ist denkbar, dass der Reflexionsabschnitt und der Blendenabschnitt zumindest teilweise einen gemeinsamen Abschnitt des Optikhalters ausbilden.

Vorzugsweise weist die Optikausnehmung einen Querschnitt in Form eines Kreissegments oder eines Kreisabschnitts auf. Der die Blendenkante bildende Wandungsabschnitt der Optikausnehmung erstreckt sich dann beispielsweise entlang der Kreissehne der kreissegmentförmigen Optikausnehmung. Des Weiteren kann sich die Kreissehne im Parallelabstand zu den Verbindungskanten zwischen dem Halteabschnitt und den Befestigungsschenkeln erstrecken. Vorzugsweise ist die Kreissehne etwas mittig des Halteabschnitts vorgesehen. Es ist denkbar die Optikausnehmung elliptisch oder mit einer anderen Form auszugestalten. Außerdem kann die Blendenkante alternativ auch eine Bogenform oder sonstige Form haben.

In weiterer Ausgestaltung der Erfindung kann der Optikhalter, insbesondere der Halteabschnitt, zumindest eine Bohrung oder Durchgangsbohrung aufweisen. In diese kann dann vorteilhafterweise ein Fixierelement eingespritzt sein, dass mit der Optik, insbesondere einstückig, verbunden ist. Somit kann das Fixierelement beispielsweise einen Teil der Optik bilden. Hierdurch kann die Optik in einer Vorzugsrichtung fixiert werden. Dies ist insbesondere vorteilhaft, wenn die Optik aus Silikon ausgebildet ist und aufgrund des großen Temperaturkoeffizienten sich ausdehnt oder schrumpft. Beispielsweise ist das Fixierelement vorrichtungstechnisch einfach als Stift ausgebildet, der die Bohrung durchsetzt. Der Stift kann dann über einen Steg mit der Optik verbunden sein, wobei sich der Steg beispielsweise an der Oberseite des Halteabschnitts erstreckt. In weiterer Ausgestaltung sind zwei oder mehr Fixierelemente vorgesehen, die in einer jeweiligen Bohrung eingespritzt sind. Zwei Fixierelemente können beispielsweise etwa diagonal und/oder symmetrisch bezüglich der Optik angeordnet sein.

Die Optik ist vorzugsweise als Linse ausgebildet. In weiterer Ausgestaltung der Erfindung ist denkbar, eine Mehrzahl von Optiken vorzusehen, die jeweils über den Optikhalter befestigt sind. Die Mehrzahl von Optiken sind beispielsweise in einer Reihe oder in einer Matrix anordbar. Außerdem ist denkbar die Optiken einstückig auszubilden und miteinander zu verbinden. Ist eine einzelne Optik vorgesehen, so kann diese über eine einzelne Strahlungsquelle oder mehrere Strahlungsquellen angebracht werden. Ist ein einzeiliger oder mehrzelliger Optikverbund oder Linsenverbund vorgesehen, kann dieser über eine ein- oder zweidimensionale Strahlungsquellen-Matrix angebracht sein.

Besonders vorteilhaft handelt es sich bei der Linse um eine totale interne Reflexionslinse (TIR-Linse), die eine äußerst hohe optische Effizienz hat.

Vorzugsweise ist eine Einkoppelseite der Optik konkav oder konvex ausgebildet. Somit kann die Optik beispielsweise einkoppelseitig als konkave oder konvexe Linse ausgebildet sein. Alternativ oder zusätzlich kann vorgesehen sein, dass die Optik einkoppelseitig als Lichtleiter ausgebildet ist. Alternativ oder zusätzlich ist auch denkbar, dass der Optik einkoppelseitig ein Lichtleiter zugeordnet ist. Die Einkoppelseite der Optik kann auch in anderen unterschiedlichsten Formen ausgebildet sein.

Erfindungsgemäß ist eine Beleuchtungsanordnung mit zumindest einer Optikvorrichtung gemäß einem oder mehrerer der vorhergehenden Aspekte vorgesehen. Die Beleuchtungsanordnung hat vorzugsweise eine Leiterplatte, auf der eine Strahlungsquelle befestigt und elektrisch kontaktiert ist. Der Optikhalter kann dann auf der Leiterplatte derart befestigt sein, dass die Optik im Strahlengang einer von der Strahlungsquelle emittierbaren Strahlung oder in der optischen Hauptachse der Strahlungsquelle liegt. Diese Lösung führt zu äußerst geringen Toleranzen, da zur Befestigung der Optik nur ein einziges Bauteil eingesetzt ist. Außerdem führt eine derartige Beleuchtungsanordnung zu einer hohen Effizienz und kann mit wenigen Montageschritten vorrichtungstechnisch einfach und kostengünstig hergestellt werden.

Bei der Strahlungsquelle handelt es sich vorzugsweise um eine lichtemittierende Diode (LED). Diese kann in Form mindestens einer einzeln gehäusten LED oder in Form mindestens eines LED-Chips, der eine oder mehrere Leuchtdioden aufweist, vorliegen. Es können mehrere LED-Chips auf einem gemeinsamen Substrat ("Submount") montiert sein und eine LED bilden oder einzeln oder gemeinsam beispielsweise auf einer Platine (z.B. FR4, Metallkernplatine, etc.) befestigt sein ("CoB" = Chip on Board). Die mindestens eine LED kann mit mindestens einer eigenen und/oder gemeinsamen Optik zur Strahlführung ausgerüstet sein, beispielsweise mit mindestens einer Fresnel-Linse oder einem Kollimator. Anstelle oder zusätzlich zu anorganischen LEDs, beispielsweise auf Basis von AlInGaN oder InGaN oder AlInGaP, sind allgemein auch organische LEDs (OLEDs, z.B. Polymer-OLEDs) einsetzbar. Die LED-Chips können direkt emittierend sein oder einen vorgelagerten Leuchtstoff aufweisen. Alternativ kann die lichtemittierende Komponente eine Laserdiode oder eine Laserdiodenanordnung sein. Denkbar ist auch eine OLED-Leuchtschicht oder mehrere OLED-Leuchtschichten oder einen OLED-Leuchtbereich vorzusehen. Die Emissionswellenlängen der lichtemittierenden Komponenten können im ultravioletten, sichtbaren oder infraroten Spektralbereich liegen. Die lichtemittierenden Komponenten können zusätzlich mit einem eigenen Konverter ausgestattet sein. Bevorzugt emittieren die LED-Chips weißes Licht im genormten ECE-Weißfeld der Automobilindustrie, beispielsweise realisiert durch einen blauen Emitter und einen gelb/grünen Konverter.

Der Optikhalter wird beispielsweise mit einem Klebstoff auf der Leiterplatte befestigt. Zusätzlich oder alternativ ist denkbar den Optikhalter mit der Leiterplatte zu verlöten. Ist eine zusätzliche Verlötung vorgesehen, so erfolgt das Verlöten vorzugsweise nach dem Befestigen des Optikhalters mit dem Klebstoff auf der Leiterplatte. Somit kann die Optikvorrichtung als Surface-Mount-Device (SMD) oder oberflächenmontiertes Bauelement vorrichtungstechnisch einfach montiert werden. Es kann beispielsweise hierdurch mit denselben Toleranzen wie die Strahlungsquelle, insbesondere die LED, platziert, verklebt und verlötet werden, insbesondere wenn es sich bei der Strahlungsquelle auch um ein SMD handelt. Beispielsweise kann dann die Optikvorrichtung mit einer Genauigkeit von 75 µm, prozessicher, montiert werden. Die Verklebung kann dann als Vormontage dienen. Durch die Markierung an der Optik und/oder am Optikhalter kann auf einfache Weise eine Justage bei der Beleuchtungsanordnung erfolgen. Hierbei kann eine Kamera eingesetzt sein. Insbesondere kann eine Justage in einer X- und Y-Richtung erfolgen, also in einer Ebene parallel zur Leiterplatte. Mit anderen Worten kann vorgesehen sein, die Optikvorrichtung mithilfe einer Advanced Surface Mount Technology (SMT)zu montieren.

Wie vorstehend bereits erläutert, kann die Verbindung des Optikhalters mit der Leiterplatte durch Verlöten erfolgen, wenn dieser aus einem lötbaren Material ausgebildet ist. Der Lötprozess kann hierbei allerdings optional sein. Vorzugsweise erfolgt eine Verlötung, wenn der Optikhalter zusätzlich als Kühlkörper eingesetzt wird. Erfolgt ein Einsatz des Optikhalters als Kühlkörper, so kann die Optik optimal auf eine Arbeitstemperatur ausgelegt werden, da der Optikhalter eine homogene Temperatur aufweist.

In weiterer Ausgestaltung kann der Optikvorrichtung eine Sekundäroptik nachgeschaltet sein. So ist beispielsweise die Optik, die im Optikhalter vorgesehen ist, eine Primäroptik. Beispielsweise ist die Primäroptik dann derart geformt, dass am Blendenabschnitt ein gewünschtes Lichtbild erzeugt wird, welches dann von der Sekundäroptik, die insbesondere als Linse ausgebildet ist, in ein Fernfeld abgebildet wird.

Auf der Leiterplatte ist beispielsweise eine einzelne LED oder sind LEDs vorgesehen, die einreihig oder mehrreihig oder matrixartig angeordnet sind.

Erfindungsgemäß ist ein Scheinwerfer mit einer Beleuchtungsanordnung gemäß einem der vorhergehenden Aspekte vorgesehen. Der Scheinwerfer wird vorzugsweise bei einem Fahrzeug eingesetzt. Das Fahrzeug kann ein Luftfahrzeug oder ein wassergebundenes Fahrzeug oder ein landgebundenes Fahrzeug sein. Das landgebundene Fahrzeug kann ein Kraftfahrzeug oder ein Schienenfahrzeug oder ein Fahrrad sein. Besonders bevorzugt ist das Fahrzeug ein Lastkraftwagen oder ein Personenkraftwagen oder ein Kraftrad. Das Fahrzeug kann des Weiteren als nicht-autonomes oder teilautonomes oder autonomes Fahrzeug ausgestaltet sein. Wird der Scheinwerfer für ein Fahrzeug eingesetzt, so handelt es sich dann bei diesem vorzugsweise um einen Frontscheinwerfer.

Des Weiteren ist ein Verfahren zum Herstellen einer Optikvorrichtung gemäß einem oder mehrerer der vorhergehenden Aspekte mit folgenden Schritten vorgesehen:
- Einlegen des Optikhalters in eine Kavität eines Spritzgusswerkzeugs als Einlegeteil,
- Einspritzen eines Gussmaterials, insbesondere Silikon, in die Kavität, um die Optik auszubilden, wobei dann der Optikhalter hierbei umspritzt wird.

Mit dem Verfahren kann die Optikvorrichtung in vorteilhafter Weise mit wenigen Herstellungsschritten hergestellt werden.

Im Folgenden soll die Erfindung anhand von Ausführungsbeispielen näher erläutert werden. Die Figuren zeigen:
- Fig. 1: in einer perspektivischen Darstellung eine Beleuchtungsanordnung gemäß einer Ausführungsform,
- Fig. 2: in einer perspektivischen Darstellung einen Optikhalter der Beleuchtungsanordnung aus Figur 1,
- Fig. 3: in einer perspektivischen Darstellung eine Optikvorrichtung mit dem Optikhalter aus Figur 2 und einer Optik,
- Fig. 4a und 4b: unterschiedliche Ansichten einer Optikvorrichtung gemäß einer weiteren Ausführungsform, und
- Fig. 5: ein Ablaufdiagramm eines Verfahrens gemäß einer Ausführungsform.

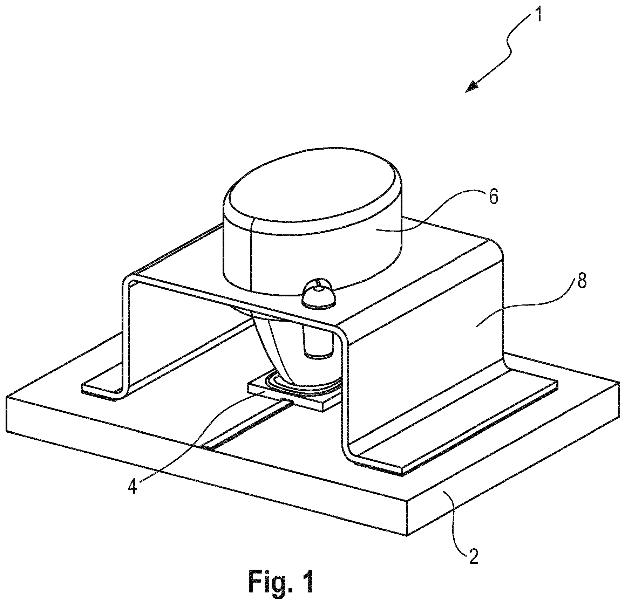

Gemäß Figur 1 ist eine Beleuchtungsanordnung 1 dargestellt, die beispielsweise in einem Scheinwerfer für ein Fahrzeug eingesetzt ist. Diese hat eine Leiterplatte 2, auf der eine Licht emittierende Diode (LED) 4 befestigt ist. Der LED 4 ist eine Optik 6 in Form einer Totalen Internen Reflexionslinse (TIR-Linse) nachgeschaltet. Die Optik 6 ist hierbei als Primäroptik eingesetzt. Zum Befestigen der Optik 6 ist ein bügelartiger Optikhalter 8 vorgesehen, der über ein Lot und/oder über einen Klebstoff an der Leiterplatte 2 befestigt ist.

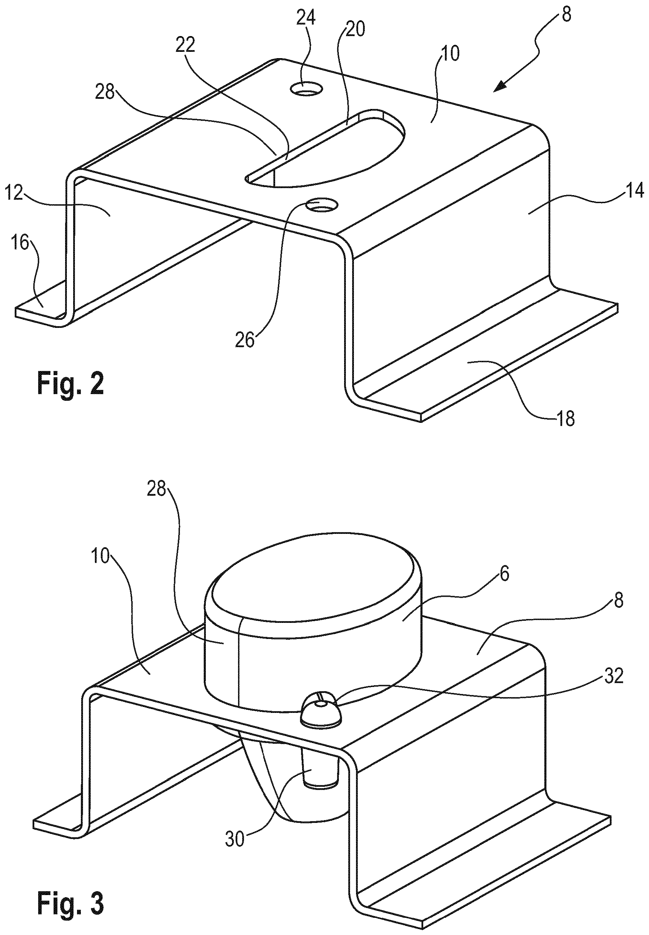

Gemäß Figur 2 hat der U-förmige Optikhalter 8 einen Halteabschnitt 10 für die Optik 6 aus Figur 1 und zwei sich davon weg erstreckende Befestigungsschenkel 12 und 14. Von einem jeweiligen Befestigungsschenkel 12 und 14 erstreckt sich ein jeweils ein Anlageabschnitt 16 und 18 nach außen. Über diese ist der Optikhalter 8 an der Leiterplatte 2, siehe auch Figur 1, über eine Löt- und/oder Klebeverbindung festgelegt. Die Anlageabschnitte 16, 18 erstrecken sich im Parallelabstand zum Halteabschnitt 10. In dem Halteabschnitt 10 ist eine durchgängige Optikausnehmung 20 eingebracht. Diese ist hierbei kreissegmentartig ausgestaltet und weist eine gerade Kreissehne 22 auf. Denkbar ist alternativ die Optikaussparung elliptisch oder kreisförmig auszubilden. Diese bildet eine Blendenkante aus. Benachbart zur Optikausnehmung 20 sind zwei durchgängige Bohrungen 24 und 26 in den Halteabschnitt 10 eingebracht.

Gemäß Figur 3 ist der Optikhalter 8 zusammen mit der Optik 6 dargestellt. Diese durchsetzt hierbei die Optikausnehmung 20 aus Figur 2. Des Weiteren übergreift die Optik 6 den Halteabschnitt 10 auf seiner Oberseite und Unterseite. Ein Symmetrieachse eines Querschnitts eines von der Oberseite wegkragenden Abschnitts 28 der Optik 6 ist hierbei in Richtung der optischen Hauptachse gesehen parallel und benachbart zur Kreissehne 22, siehe Figur 2, angeordnet. Gemäß Figur 2 bildet dann ein von der Kreissehne 22 ausgehender Abschnitt des Halteabschnitts 10 einen Blendenabschnitt 28, der von der Optik 6 beidseitig übergriffen ist.

Gemäß Figur 3 ist in die Bohrung 26, siehe auch Figur 2, ein stiftartiges Fixierelement 30 eingesetzt, das über einen Steg 32 einstückig mit der Optik 6 verbunden ist. In die andere Bohrung 24, siehe Figur 2, ist ebenfalls ein Fixierelement eingesetzt, das gemäß der Darstellung in Figur 3 von der Optik 6 verdeckt ist.

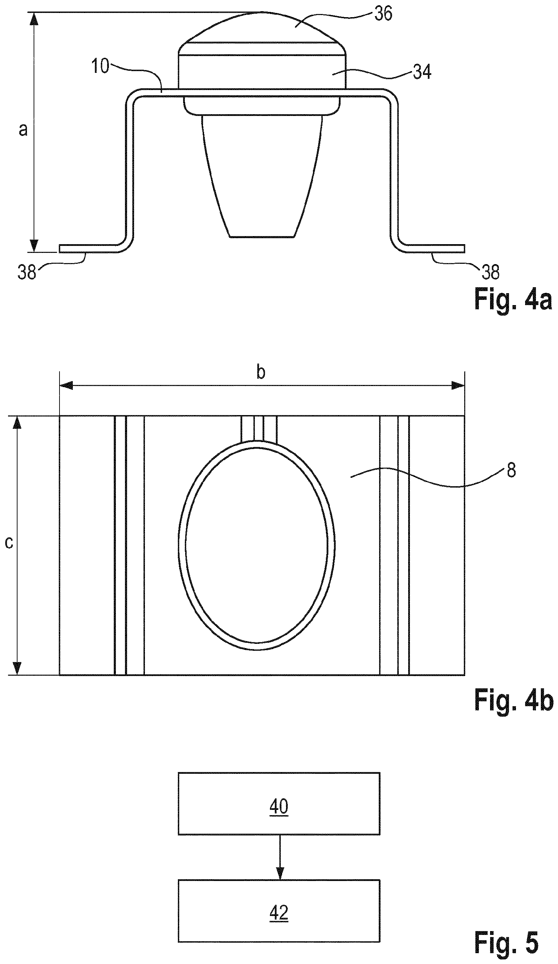

Gemäß Figur 4a ist eine Seitenansicht einer Optikvorrichtung gemäß einer weiteren Ausführungsform gezeigt. Eine als TIR-Linse ausgebildete Optik 34 hat hierbei eine konvexe Auskoppelfläche 36. Des Weiteren ist erkennbar, dass ein von einer Oberseite des Halteabschnitts 10 wegkragender Optikabschnitt einen größeren Durchmesser als ein von der Unterseite wegkragender Optikabschnitt aufweist. Ein Abstand a, der sich von einer Anlagefläche 38 der Anlageabschnitte 16 und 18 bis zum von den Anlageflächen 38 wegweisenden Ende der Optik 34 in Richtung der optischen Hauptachse gesehen erstreckt, beträgt 10 mm. In der Draufsicht gemäß Figur 4b auf die Optikvorrichtung ist eine Länge b und eine Breite c des Optikhalters 8 gezeigt. Die Länge b und die Breite c erstrecken sich hierbei im Parallelabstand zur Leiterplatte, siehe Figur 1. Die Länge b des Optikhalters 8 beträgt hierbei 15,5 mm und die Breite c 11 mm.

Gemäß Figur 5 ist in einem Verfahren zum Herstellen der Optikvorrichtung gemäß Figur 3 und Figur 4a in einem ersten Schritt 40 vorgesehen, dass der Optikhalter 8 in eine Kavität eines Spritzgusswerkzeugs als Einlegeteil eingelegt wird. Im folgenden Schritt 42 wird dann der Optikhalter 8 von der Optik 6 oder 34 umspritzt. Hierbei werden des Weiteren gemäß Figur 3 die Fixierelemente 30 ausgebildet.

Offenbart ist eine Optikvorrichtung mit einem bügelartigen Optikhalter, der im Spritzgussverfahren von einer Optik umspritzt ist. Die Optik ist dann über den Optikhalter an einer Leiterplatte festlegbar.

**BEZUGSZEICHENLISTE**

| | |
|---|---|
| Beleuchtungsanordnung | 1 |
| Leiterplatte | 2 |
| LED | 4 |
| Optik | 6, 34 |
| Optikhalter | 8 |
| Halteabschnitt | 10 |
| Befestigungsschenkel | 12, 14 |
| Anlageabschnitt | 16, 18 |
| Optikausnehmung | 20 |
| Kreissehne | 22 |
| Bohrung | 24, 26 |
| Blendenabschnitt | 28 |
| Fixierelement | 30 |
| Steg | 32 |
| Auskoppelfläche | 36 |
| Anlagefläche | 38 |
| Schritt | 40, 42 |

## Patentansprüche

1. Optikvorrichtung mit einer Optik (6; 34) und mit einem Optikhalter (8), über den die Optik (6; 34) an einer Leiterplatte (2) befestigbar ist, wobei eine Optikausnehmung (20) in den Optikhalter (8) eingebracht ist, wobei die Optik (6; 34) ausgehend von der Optikausnehmung (20) eine Oberseite des Optikhalters (8) und eine Unterseite des Optikhalters (8) übergreift, wobei die Optik (6; 34) über ein Spritzgussverfahren hergestellt ist, und der Optikhalter (8) von der Optik (6; 34) umspritzt ist, wobei der Optikhalter (8) zumindest einen Funktionsabschnitt aufweist zur Beeinflussung einer Strahlungsverteilung einer Strahlung, die von zumindest einer der Optik (6; 34) zuordbaren Strahlungsquelle (4) emittierbar ist, wobei der Funktionsabschnitt als ein Blendenabschnitt (28) ausgebildet ist, der als Blende eingesetzt ist, und/oder wobei der Funktionsabschnitt als Reflexionsabschnitt ausgebildet ist.

2. Optikvorrichtung nach Anspruch 1, wobei die Optik (6; 34) aus Silikon ausgebildet ist.

3. Optikvorrichtung nach Anspruch 1 oder 2, wobei der Optikhalter (8) einen Halteabschnitt (10) für die Optik (6; 34) und zumindest einen mit dem Halteabschnitt (10) verbundenen Befestigungsschenkel (12, 14) für die Befestigung des Optikhalters (8) an der Leiterplatte (2) aufweist.

4. Optikvorrichtung nach Anspruch 3, wobei der Halteabschnitt (10) und der zumindest eine Befestigungsschenkel (12, 14) als Flachteile ausgebildet sind.

5. Optikvorrichtung nach einem der vorhergehenden Ansprüche, wobei der Optikhalter (8) als Blechbiegeteil oder aus Kunststoff gebildet ist.

6. Optikvorrichtung nach einem der Ansprüche 3 bis 5, wobei der Optikhalter (8) zwei Befestigungsschenkel (12, 14) hat, die sich jeweils vom Halteabschnitt (10) wegerstrecken und zusammen mit diesem U-förmig ausgebildet sind.

7. Optikvorrichtung nach einem der vorhergehenden Ansprüche, wobei in den Optikhalter (8) zumindest eine Bohrung (24, 26) eingebracht ist, die von einem Fixierelement (30) umspritzt ist, das mit der Optik (6) verbunden ist.

8. Beleuchtungsanordnung mit zumindest einer Optikvorrichtung gemäß einem der vorhergehenden Ansprüche, wobei eine Leiterplatte (2) vorgesehen ist, auf der zumindest eine Strahlungsquelle (4) befestigt ist, wobei der Optikhalter (8) auf der Leierplatte (2) derart befestigt ist, dass die Optik (8) im Strahlengang der von der Strahlungsquelle (4) emittierbaren Strahlung liegt.

9. Scheinwerfer mit einer Beleuchtungsanordnung gemäß Anspruch 8.

## Claims

1. Optical apparatus comprising an optical unit (6; 34) and comprising an optical unit holder (8), by means of which the optical unit (6; 34) is able to be secured to a printed circuit board (2), wherein an optical unit cutout (20) is introduced into the optical unit holder (8), wherein the optical unit (6; 34), proceeding from the optical unit cutout (20), extends over a top side of the optical unit holder (8) and an underside of the optical unit holder (8), wherein the optical unit (6; 34) is produced by means of an injection-moulding method, and the optical unit (6; 34) is injection-moulded around the optical unit holder (8), wherein the optical unit holder (8) has at least one functional portion for influencing a radiation distribution of radiation that is emitable by at least one radiation source (4) assignable to the optical unit (6; 34), wherein the functional portion is embodied as a stop portion (28) used as a stop, and/or wherein the functional portion is embodied as a reflection portion.

2. Optical apparatus according to Claim 1, wherein the optical unit (6; 34) is embodied from silicone.

3. Optical apparatus according to Claim 1 or 2, wherein the optical unit holder (8) has a holding portion (10) for the optical unit (6; 34) and at least one securing limb (12, 14) for securing the optical unit holder (8) to the printed circuit board (2), said at least one securing limb being connected to the holding portion (10).

4. Optical apparatus according to Claim 3, wherein the holding portion (10) and the at least one securing limb (12, 14) are embodied as flat parts.

5. Optical apparatus according to any of the preceding claims, wherein the optical unit holder (8) is formed as a bent sheet-metal part or from plastic.

6. Optical apparatus according to one of Claims 3 to 5, wherein the optical unit holder (8) has two securing limbs (12, 14), which each extend away from the holding portion (10) and together with the latter are embodied in a U-shaped fashion.

7. Optical apparatus according to any of the preceding claims, wherein at least one hole (24, 26) is introduced into the optical unit holder (8), a fixing element (30) being injection-moulded around said at least one hole and said fixing element being connected to the optical unit (6).

8. Lighting arrangement comprising at least one optical apparatus according to any of the preceding claims, wherein a printed circuit board (2) is provided, on which at least one radiation source (4) is secured, wherein the optical unit holder (8) is secured on the printed circuit board (2) in such a way that the optical unit (8) lies in the beam path of the radiation emitable by the radiation source (4).

9. Headlight comprising a lighting arrangement according to Claim 8.

## Revendications

1. Dispositif optique avec une optique (6 ; 34) et avec un support d'optique (8), par l'intermédiaire duquel l'optique (6 ; 34) est fixable sur une carte de circuit imprimé (2), dans lequel une cavité optique (20) est ménagée dans le support d'optique (8), dans lequel l'optique (6 ; 34), à partir de la cavité optique (20), chevauche une face supérieure du support d'optique (8) et une face inférieure du support d'optique (8), dans lequel l'optique (6 ; 34) est fabriquée par l'intermédiaire d'un procédé de moulage par injection, et le support d'optique (8) est surmoulé par l'optique (6 ; 34), dans lequel le support d'optique (8) comprend au moins une partie fonctionnelle pour influencer une distribution de rayonnement d'un rayonnement qui peut être émis par au moins une source de rayonnement (4) associable à l'optique (6 ; 34), dans lequel la partie fonctionnelle est conçue en tant que partie obturateur (28) qui est utilisée en tant qu'obturateur, et/ou dans lequel la partie fonctionnelle est conçue en tant que partie réfléchissante.

2. Dispositif optique selon la revendication 1, dans lequel l'optique (6 ; 34) est conçue à partir de silicone.

3. Dispositif optique selon la revendication 1 ou la revendication 2, dans lequel le support d'optique (8) comprend une partie de support (10) pour l'optique (6 ; 34) et au moins un bras de fixation (12, 14) relié à la partie de support (10) pour la fixation du support d'optique (8) sur la carte de circuit imprimé (2).

4. Dispositif optique selon la revendication 3, dans lequel la partie de support (10) et l'au moins un bras de fixation (12, 14) sont conçus en tant que pièces plates.

5. Dispositif optique selon l'une des revendications précédentes, dans lequel le support d'optique (8) est formé en tant que pièce pliée en tôle ou à partir de matière plastique.

6. Dispositif optique selon l'une des revendications 3 à 5, dans lequel le support d'optique (8) a deux bras de fixation (12, 14), lesquels s'étendent respectivement à partir de la partie de support (10) et sont conçus conjointement avec celle-ci en forme de U.

7. Dispositif optique selon l'une des revendications précédentes, dans lequel dans le support d'optique (8) est ménagé au moins un trou (24, 26), lequel est surmoulé par un élément fixateur (30) qui est relié à l'optique (6).

8. Agencement d'éclairage avec au moins un dispositif optique selon l'une des revendications précédentes, dans lequel est prévue une carte de circuit imprimé (2), sur laquelle est fixée au moins une source de rayonnement (4), dans lequel le support d'optique (8) est fixé sur la carte de circuit imprimé (2) de telle sorte que l'optique (8) se situe dans le trajet de rayonnement du rayonnement pouvant être émis par la source de rayonnement (4).

9. Phare avec un agencement d'éclairage selon la revendication 8.
